(19) Europäisches Patentamt
European Patent Office
Office européen des brevets

(11) EP 4 644 441 A1

(12) **EUROPEAN PATENT APPLICATION**
published in accordance with Art. 153(4) EPC

(43) Date of publication:
**05.11.2025 Bulletin 2025/45**

(21) Application number: **23848372.1**

(22) Date of filing: **19.05.2023**

(51) International Patent Classification (IPC):
***C08F 222/10*** (2006.01) ***C08F 220/18*** (2006.01)
***C08F 2/50*** (2006.01) ***C09D 4/00*** (2006.01)
***H10K 59/10*** (2023.01)

(52) Cooperative Patent Classification (CPC):
**C08F 2/50; C08F 220/18; C08F 222/10; C09D 4/00; H10K 59/10**

(86) International application number:
**PCT/KR2023/006829**

(87) International publication number:
**WO 2024/143723 (04.07.2024 Gazette 2024/27)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **30.12.2022 KR 20220190347**

(71) Applicant: **Solus Advanced Materials Co., Ltd.**
**Iksan-si, Jeollabuk-do 54588 (KR)**

(72) Inventors:
- **NOH, Seungjoo**
  **Yongin-si, Gyeonggi-do 16858 (KR)**
- **KONG, Yisung**
  **Yongin-si, Gyeonggi-do 16858 (KR)**

(74) Representative: **Office Freylinger**
**P.O. Box 48**
**8001 Strassen (LU)**

# (54) COMPOSITION FOR ORGANIC LIGHT-EMITTING ELEMENT ENCAPSULATION AND ORGANIC LIGHT-EMITTING DISPLAY DEVICE COMPRISING SAME

(57) The present invention relates to a composition for encapsulating an organic light-emitting device and an organic light-emitting display apparatus including the same, and more specifically, to a composition for encapsulating an organic light-emitting device and an organic light-emitting display apparatus including the same, wherein the composition not only secures the performance and lifespan of an organic light-emitting device by effectively blocking, from the outside, moisture or oxygen flowing into an organic light-emitting display apparatus, but also has low permittivity characteristics to improve touch sensitivity of a touch panel.

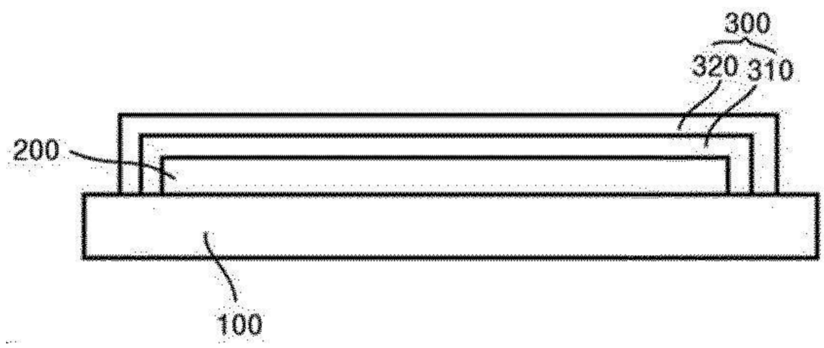


FIGURE 1

EP 4 644 441 A1

## Description

### [Technical Field]

The present invention relates to a composition for encapsulating an organic light-emitting device and an organic light-emitting display apparatus including the same, and more specifically, to a composition for encapsulating an organic light-emitting device and an organic light-emitting display apparatus including the same, wherein the composition not only secures the performance and lifespan of an organic light-emitting device by effectively blocking, from the outside, moisture or oxygen flowing into an organic light-emitting display apparatus, but also has low permittivity characteristics to improve the touch sensitivity of a touch panel.

### [Background Art]

An organic layer material, an electrode, etc. of an organic light-emitting device have a problem in that the luminescence characteristics and lifespan thereof may deteriorate due to external moisture or oxygen. Therefore, a protective layer, which may protect an organic material and an electrode, is needed. The protective layer usually includes a structure of a stack of one or more organic layers and one or more inorganic layer to effectively block external moisture or oxygen.

Recently, capacitive touch panels using organic light-emitting devices have been widely used. These capacitive touch panels detect touch by a change in capacitance when a conductor comes into contact with the touch panels, and in the case of a high permittivity material, when an external electric field is present, a lot of polarization occurs, which tends to decrease touch sensitivity. Therefore, there is a demand for the development of a composition for encapsulating an organic layer used in a stack structure, the composition having low permittivity characteristics and allowing excellent touch sensitivity of a touch panel.

### [Disclosure]

### [Technical Problem]

The present invention aims to provide a composition for encapsulating an organic light-emitting device and an organic light-emitting display apparatus including the same, wherein the composition not only secures the performance and lifespan of an organic light-emitting device by effectively blocking, from the outside, moisture or oxygen flowing into an organic light-emitting display apparatus, but also has low permittivity characteristics to ensure excellent touch sensitivity of a touch panel.

### [Technical Solution]

In order to solve the above problem, the present invention provides a composition for encapsulating an organic light-emitting device, the composition including: a photocurable monomer including all monomers represented by Chemical Formulae 1 to 3; and a photopolymerization initiator, wherein the composition for encapsulating the organic light-emitting device may have a permittivity of 2.65 or less at a frequency in the range of 100 kHz to 1 MHz, and may have a ring parameter of 0.01 to 0.25.

[Chemical Formula 1]

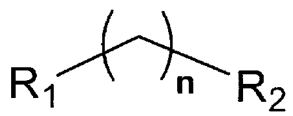

[Chemical Formula 2]

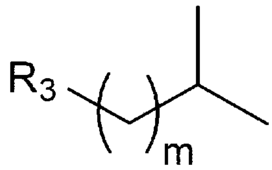

[Chemical Formula 3]

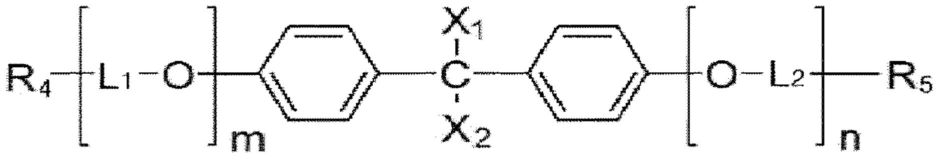

In Chemical Formulae 1 to 3,

$R_1$ to $R_5$ are each independently a (meth)acryloyl group,
$L_1$ and $L_2$ are each independently a substituted or unsubstituted $C_{1-10}$ alkylene group,
$X_1$ and $X_2$ are each independently hydrogen or a $C_{1-10}$ alkyl group, and
m and n are each an integer from 1 to 4.

The present invention also provides an organic light-emitting display apparatus including an encapsulation portion containing the composition for encapsulating the organic light-emitting device.

**[Advantageous Effects]**

When an encapsulation portion of an organic light-emitting display apparatus is formed by using a composition for encapsulating an organic light-emitting device, according to the present invention, the performance and lifespan of an organic light-emitting device may be secured by effectively blocking moisture or oxygen flowing from the outside, and due to low permittivity characteristics, the touch sensitivity of a touch panel is excellent.

**[Description of Drawing]**

FIGURE 1 is an example view of an organic light-emitting display apparatus according to an embodiment of the present invention.

**[Mode for Invention]**

Hereinafter, embodiments of the present invention will be described in detail with reference to the accompanying drawing.

In adding reference numerals to components in each drawing, it should be noted that the same reference numerals are assigned to the same components as much as possible even when the same components are shown in different drawings. In addition, in describing the present invention, when it is determined that a detailed description of a related known configuration or function may obscure the gist of the present invention, the detailed description thereof will be omitted.

When a component is "connected," "coupled," or "accessed" with another component, the component may be directly connected with or accessed with the other component, but another component may be "connected," "coupled," or "accessed" therebetween. Furthermore, when a component, such as a layer, a film, a region, a plate, is referred to as being formed "above" or "on" another component, it may include a case in which the component is formed "directly on" the other component and a case in which intervening component is present therebetween. In contrast, when a component is formed "directly on" another component, it indicates that there is no other component therebetween.

The term "(meth)acryl" used in the present specification refers to acryl and/or methacryl.

Unless otherwise specified, the term "alkyl group" used in the present specification has 1 to 60 carbon atoms

linked to each other via a single bond, and refers to a radical of a saturated aliphatic functional group, including a straight-chain alkyl group, a branched-chain alkyl group, a cycloalkyl(alicyclic) group, an alkyl-substituted cycloalkyl group, a cycloalkyl-substituted alkyl group.

The term "alkylene group" used in the present specification refers to alkanediyl groups linked to each other via saturated hydrocarbon without a double bond, and has two linking groups.

In addition, unless explicitly stated, "substituted" in the term "substituted or unsubstituted" used in the present specification refers to substitution with one or more substituents selected from the group consisting of deuterium, halogen, an amino group, a nitrile group, a nitro group, a $C_{1-20}$ alkyl group, a $C_{1-20}$ alkoxy group, a $C_{1-20}$ alkylamine group, a $C_{1-20}$ alkylthiophene group, a $C_{6-20}$ arylthiophene group, a $C_{2-20}$ alkenyl group, a $C_{2-20}$ alkynyl group, a $C_{3-20}$ cycloalkyl group, a $C_{6-20}$ aryl group, a $C_{6-20}$ aryl group substituted with deuterium, a $C_{8-20}$ arylalkenyl group, a silane group, a boron group, and a $C_{2-20}$ heterocyclic group including at least one heteroatom selected from the group consisting of O, N, S, Si, and P, but substituents not necessarily limited to theses substituents.

The term "permittivity" used in the present specification refers to a value measured by the capacitance method for an organic layer including a composition for encapsulating an organic light-emitting device, according to the present invention.

The term "viscosity" used in the present specification refers to a value measured using a rotational viscometer for an organic layer including a composition for encapsulating an organic light-emitting device, according to the present invention.

A composition for encapsulating an organic light-emitting device, according to the present invention, includes: a photocurable monomer including all monomers represented by Chemical Formulae 1 to 3; and a photopolymerization initiator.

In addition, the composition for encapsulating the organic light-emitting device, according to the present invention, may have a permittivity of 2.65 or less at a frequency in the range of 100 kHz to 1 MHz, a ring parameter of 0.01 to 0.25, and a viscosity of 10 cPs to 20 cPs. For reference, the ring parameter refers to the molecular weight of carbon included in a cyclo or phenyl ring divided by the total molecular weight, and may be defined by Equation 1.

[Equation 1]

$$Ring\ parameter = \frac{Mass_{carbon\ in\ ring}}{Mass_{total\ component}}$$

[Chemical Formula 1]

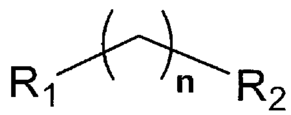

[Chemical Formula 2]

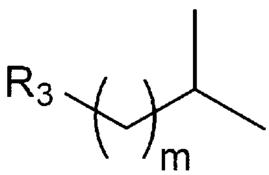

[Chemical Formula 3]

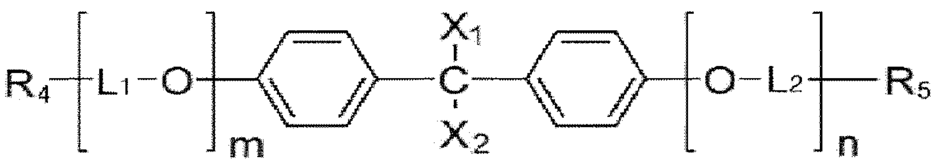

In Chemical Formulae 1 to 3,

$R_1$ to $R_5$ are each independently a (meth)acryloyl group,
$L_1$ and $L_2$ are each independently a substituted or unsubstituted $C_{1-10}$ alkylene group,
$X_1$ and $X_2$ are each independently hydrogen or a $C_{1-10}$ alkyl group, and
m and n are each an integer from 1 to 4.

The monomer represented by Chemical Formula 1 may be one or more selected from the group consisting of 1,14-tetradecanediol di(meth)acrylate, 1,15-pentadecanediol di(meth)acrylate, 1,16-hexadecanediol di(meth)acrylate, 1,17-heptadecanediol di(meth)acrylate, and 1,18-octadecanediol di(meth)acrylate, but is not necessarily limited thereto.

In addition, the monomer represented by Chemical Formula 2 may be one or more selected from the group consisting of isotetradecyl (meth)acrylate, isopentadecyl (meth)acrylate, isohexadecyl (meth)acrylate, isoheptadecyl (meth)acrylate, and isooctadecyl (meth)acrylate, but is not necessarily limited thereto.

The monomer represented by Chemical Formula 3 may be one or more selected from the group consisting of bisphenol-A ethylene oxide diacrylate, bisphenol-A ethylene oxide dimethacrylate, bisphenol-A ethoxylate diacrylate, bisphenol-A polyethoxylate diacrylate, and bisphenol-A diacrylate, but is not necessarily limited thereto.

The photocurable monomer according to the present invention may further include one or more monomers selected from the group consisting of compounds represented by Chemical Formulae 4 to 6.

[Chemical Formula 4] $R_6$-B

[Chemical Formula 5] $R_7$-L-O-$Ar_1$

[Chemical Formula 6]

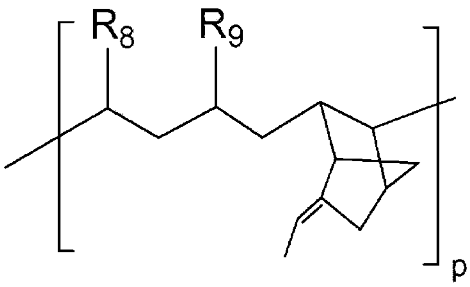

In Chemical Formulae 4 to 6,

$R_6$ and $R_7$ are each independently a (meth)acryloyl group,
A is a substituted or unsubstituted $C_{1-12}$ cycloalkylene group in which are formed two fused rings that are bridged,
B is a substituted or unsubstituted $C_{6-12}$ bridged cycloalkyl group,
L is a direct bond or a $C_{1-10}$ alkylene group,
$Ar_1$ is a $C_{6-60}$ aryl group,
one of $R_8$ and $R_9$ is hydrogen and the other one is a methyl group, and
p is an integer from 1 to 300.

A photocurable monomer represented by Chemical Formula 4 may be a compound represented by Chemical Formula 7, but is not necessarily limited thereto.

[Chemical Formula 7]

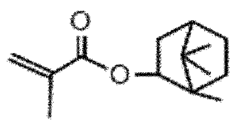

A photocurable monomer represented by Chemical Formula 5 may be a monomer selected from the group consisting of Chemical Formulae A-1 to A-3, but is not necessarily limited thereto.

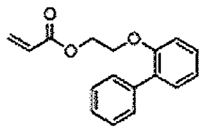
A-1

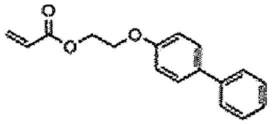
A-2

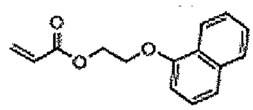
A-3

A photocurable monomer represented by Chemical Formula 6 may be ethylene propylene diene monomer (EPDM).

It is desirable that the amount of the photocurable monomer is 20 wt% to 99 wt%, based on the total weight of the composition.

More specifically, based on the total weight of the composition, the amount of the monomer represented by Chemical Formula 1 may be 15 wt% to 35 wt%, the amount of the monomer represented by Chemical Formula 2 may be 30 wt% to 65 wt%, the amount of the monomer represented by Chemical Formula 3 may be 1 wt% to 30 wt%, and the amount of each of the photocurable monomers represented by Chemical Formulae 4 to 6 may be 1 wt% to 30 wt%.

The composition for encapsulating the organic light-emitting device, according to the present invention, includes a photopolymerization initiator capable of curing the photocurable monomer through UV irradiation, etc. The photopolymerization initiator is not particularly limited as long as it is a typical photopolymerization initiator capable of performing a photocuring reaction. As an example, the photopolymerization initiator may include triazine-based, acetophenone-based, benzophenone-based, thioxanthone-based, benzoin-based, phosphorus-based, oxime-based, or a mixture thereof.

The triazine-based may be 2,4,6-trichloro-s-triazine, 2-phenyl-4,6-bis(trichloromethyl)-s-triazine, 2-(3',4'-dimethoxy styryl)-4,6-bis(trichloromethyl)-s-triazine, 2-(4'-methoxy naphthyl)-4,6-bis(trichloromethyl)-s-triazine, 2-(p-methoxy phenyl)-4,6-bis(trichloromethyl)-s-triazine, 2-(p-tolyl)-4,6-bis(trichloromethyl)-s-triazine, 2-biphenyl-4,6-bis(trichloromethyl)-s-triazine, bis(trichloromethyl)-6-styryl-s-triazine, 2-(naphtho-1-yl)-4,6-bis(trichloromethyl)-s-triazine, 2-(4-methoxynaphtho-1-yl)-4,6-bis(trichloromethyl)-s-triazine, 2,4-trichloromethyl(piperonyl)-6-triazine, 2,4-(trichloromethyl(4'-methoxy styryl)-6-triazine, or a mixture thereof.

The acetophenone-based may be 2,2'-diethoxy acetophenone, 2,2'-dibutoxy acetophenone, 2-[0230] hydroxy-2-methyl propiophenone, p-t-butyl trichloroacetophenone, p-t-butyl dichloroacetophenone, 4-chloro[0231] acetophenone, 2,2'-dichloro-4-phenoxy acetophenone, 2-methyl-1-(4-(methylthio)phenyl)-2-morpholino propan-1-one, 2-benzyl-2-dimethyl amino-1-(4-morpholino phenyl)-butan-1-one, or a mixture thereof.

The benzophenone-based may be benzophenone, benzoyl benzoic acid, benzoyl benzoate methyl, 4-phenyl benzophenone, hydroxy benzophenone, acrylic benzophenone, 4,4'-bis(dimethylamino)benzophenone, 4,4'-dichlorobenzophenone, 3,3'-dimethyl-2-methoxy benzophenone, or a mixture thereof.

The thioxanthone-based may be thioxanthone, 2-methyl thioxanthone, isopropyl thioxanthone, 2,4-diethyl thioxanthone, 2,4-diisopropyl thioxanthone, 2-chlorothioxanthone, or a mixture thereof.

The benzoin-based may be benzoin, benzoin methyl ether, benzoin ethyl ether, benzoin isopropyl ether, benzoin isobutyl ether, benzyl dimethyl ketal, or a mixture thereof.

The phosphorus-based may be bisbenzoylphenyl phosphine oxide, benzoyl diphenyl phosphine oxide, or a mixture thereof.

The oxime-based may be 2-(o-benzoyloxime)-1-[4-(phenylthio)phenyl]-1,2-octanedione and 1-(o-acetyloxime)-1-[9-ethyl-6-(2-methylbenzoyl)-9H-carbazol-3-yl]ethanone, or a mixture thereof.

It is desirable that the amount of the photopolymerization initiator is 0.1 wt% to 10 wt%, based on the total weight of the composition. This is because when the amount of the photopolymerization initiator is within the above range, sufficient photopolymerization may occur during exposure, and outgassing and a decrease in reliability, due to unreacted initiator remaining after photopolymerization, may be prevented.

The composition for encapsulating the organic light-emitting device, according to the present invention, may further include one or more additives selected from the group consisting of a surfactant, a curing accelerator, and an antioxidant. In particular, surfactants are advantageous in inducing dispersion of the composition.

The composition for encapsulating the organic light-emitting device, according to the present invention, has low permittivity characteristics, that is, a permittivity of 2.60 or less at a frequency in the range of 100 kHz to 1MHz. Thus, when the composition is applied to a touch panel, the touch sensitivity is extremely excellent.

In addition, it is desirable that the viscosity of the composition for encapsulating the organic light-emitting device, according to the present invention, is 10 cPs to 20 cPs. This is because the processability of the composition may be further

improved within the above viscosity range.

An organic light-emitting display apparatus according to the present invention includes an encapsulation portion containing the composition for encapsulating the organic light-emitting device.

FIGURE 1 is an example view of an organic light-emitting display apparatus according to an embodiment of the present invention. The organic light-emitting display apparatus shown in FIGURE 1 includes a substrate 100, an organic light-emitting device 200 disposed on the substrate 110, and an encapsulation portion 300 disposed on the organic light-emitting device 200. At this time, the encapsulation portion 300 is shown as a multilayer consisting of a first encapsulation layer 310 and a second encapsulation layer 320, but the present invention may include a structure in which the encapsulation portion 300 includes two layers or four or more layers. When the encapsulation portion 300 is formed as a multilayer of two layers, the encapsulation portion 300 may include an inorganic barrier layer and an organic barrier layer. For example, when the first encapsulation layer 310 is an inorganic barrier layer, the second encapsulation layer 320 may be an organic barrier layer, but a stacking order is not limited thereto.

The encapsulation portion 300 may form an organic barrier layer for encapsulation of an organic light-emitting display apparatus, and the organic barrier layer may be formed by photocuring the composition for encapsulating the organic light-emitting device, according to the present invention.

The composition (organic barrier layer material) may be applied by inkjet, vacuum deposition, spin coating, or slit coating, and an initiator may be used during photocuring.

Hereinafter, the present invention is described in detail with reference to Examples of the composition for encapsulating the organic light-emitting device, according to the present invention, but the present invention is not limited to the following Examples.

[Examples]

Compositions for encapsulating organic light-emitting devices, of Examples 1 to 4 were prepared by mixing 100 wt% of a photocurable monomer with 1 wt% of a photoinitiator (TPO), which are shown in Table 1.

Afterwards, the prepared compositions were stirred for 12 hours and filtered through a PTFE filter with a pore size of 0.45 μm.

Each of the filtered compositions for encapsulating the organic light-emitting devices was formed to have a thickness of 8.0 μm or more by spin coating, followed by irradiation of 1 J of light by using a UV exposure machine, thereby forming an encapsulation film. The permittivity and the viscosity were measured using the following methods.

Permittivity (or dielectric constant): A composition for encapsulating an organic light-emitting device was applied on a lower electrode to a thickness of 8.0 μm or more and cured. Afterwards, upper electrode Ag was deposited to a thickness of 1,000 Å. The prepared specimen was measured using Keysight's E4980A, and the dielectric constant (or permittivity) was calculated.

Viscosity: The viscosity of a liquid composition for encapsulating an organic light-emitting device was measured using a rotational viscometer.

As a result, each of the encapsulation films formed using the compositions for encapsulating the organic light-emitting devices in Examples 1 to 4 according to the present invention had a permittivity of 2.60 F/m or less. Accordingly, it could be confirmed that in the case of a touch panel to which the encapsulation film prepared according to the present invention was applied, a better touch sensitivity effect could be obtained.

Table 1

| No. | | Photocurable monomer | | | | | Photoinitiator | Permittivity | Viscosity | Surface tension | Transmittance |
|---|---|---|---|---|---|---|---|---|---|---|---|
| | | TDMA | BPAEMDA | IBOMA | ISTA | EPDM | (BAPO) | [F/m] | [cPs] | [mN/m] | [%] |
| | | Parts by weight | | | | | Parts by weight | | | | |
| Exam | 1 | 25 | 10 | 5 | 59.95 | 0.05 | 1 | 2.51 | 19.5 | 28.5 | 99.5 |

(continued)

| No. | | Photocurable monomer | | | | | Photoinitiator | Permittivity | Viscosity | Surface tension | Transmittance |
|---|---|---|---|---|---|---|---|---|---|---|---|
| | | TDMA | BPAEDMA | IBOMA | ISTA | EPDM | (BAPO) | [F/m] | [cPs] | [mN/m] | [%] |
| | | Parts by weight | | | | | Parts by weight | | | | |
| ples | 2 | 25 | 10 | 5 | 59 | 1 | 1 | 2.45 | 19.6 | 28.8 | 99.5 |
| | 3 | 25 | 10 | 5 | 58.5 | 1.5 | 1 | 2.41 | 19.6 | 28.5 | 99.5 |
| | 4 | 25 | 10 | 5 | 58 | 2 | 1 | 2.38 | 19.6 | 28.6 | 99.5 |

TDMA : 1,14-Tetradecanediol dimethacrylate (CAS : 168473-14-1)BPAEDMA : Bisphenol A Ethoxylate Dimethacrylate (CAS : 41637-38-1)
IBOMA : Isobornyl Acrylate (CAS : 5888-33-5)
ISTA : Isooctadecyl acrylate (CAS : 93841-48-6)
EPDM : Ethylene-Propylene-Diene Monomer (CAS : 25034-71-3)
BAPO : Bis(2,4,6-trimethylbenzoyl)-phenylphosphineoxide (CAS : 162881-26-7)

The above description is merely an illustrative description of the present invention, and those skilled in the art are able to make various modifications without departing from the essential characteristics of the present invention. Accordingly, the embodiments disclosed in the present specification should be considered in a descriptive sense only and not for purposes of limitation, and the spirit and scope of the present invention are not limited by these embodiments. The scope of protection of the present invention should be interpreted by the claims below, and all technologies within the scope equivalent thereto should be construed as being included in the scope of the present invention.

**[Description of Reference Numerals]**

100 : substrate
200 : organic light-emitting device
300 : encapsulation portion
310 : first encapsulation portion
320 : second encapsulation portion

## Claims

**1.** A composition for encapsulating an organic light-emitting device, the composition comprising: a photocurable monomer comprising all monomers represented by Chemical Formulae 1 to 3; and a photopolymerization initiator:

[Chemical Formula 1]

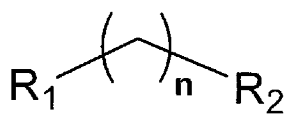

[Chemical Formula 2]

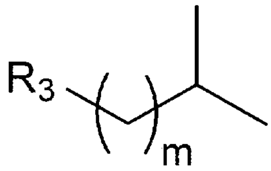

[Chemical Formula 3]

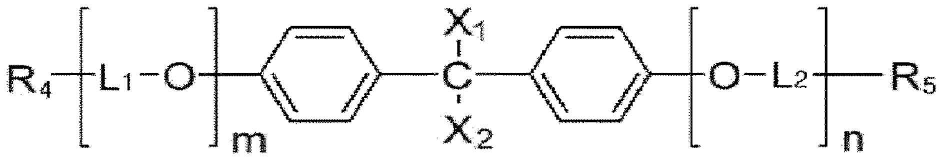

wherein, in Chemical Formulae 1 to 3,

$R_1$ to $R_5$ are each independently a (meth)acryloyl group,
$L_1$ and $L_2$ are each independently a substituted or unsubstituted $C_{1-10}$ alkylene group,
$X_1$ and $X_2$ are each independently hydrogen or a $C_{1-10}$ alkyl group, and
m and n are each an integer from 1 to 4.

**2.** The composition for encapsulating the organic light-emitting device of claim 1, wherein the composition for encapsulating the organic light-emitting device has a permittivity of 2.65 or less at a frequency in a range of 100 kHz to 1 MHz.

**3.** The composition for encapsulating the organic light-emitting device of claim 1, wherein the composition for encapsulating the organic light-emitting device has a ring parameter of 0.01 to 0.25.

**4.** The composition for encapsulating the organic light-emitting device of claim 1, wherein the photocurable monomer further comprises one or more monomers selected from the group consisting of compounds represented by Chemical Formulae 4 to 6:

[Chemical Formula 4] $R_6$-B

[Chemical Formula 5] $R_7$-L-O-$Ar_1$

[Chemical Formula 6]

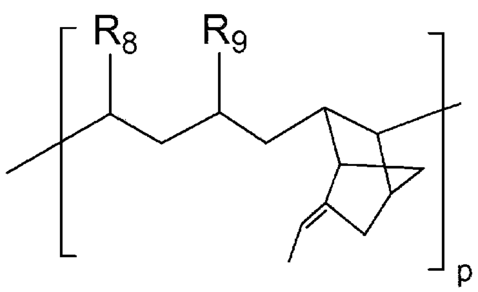

wherein, in Chemical Formulae 4 to 6,

$R_6$ and $R_7$ are each independently a (meth)acryloyl group,

A is a substituted or unsubstituted $C_{1-12}$ cycloalkylene group in which are formed two fused rings that are bridged,
B is a substituted or unsubstituted $C_{6-12}$ bridged cycloalkyl group,
L is a direct bond or a $C_{1-10}$ alkylene group,
$Ar_1$ is a $C_{6-60}$ aryl group,
one of $R_8$ and $R_9$ is hydrogen and the other one is a methyl group, and
p is an integer from 1 to 300.

**5.** The composition for encapsulating the organic light-emitting device of claim 4, wherein an amount of the photocurable monomer is 20 wt% to 99 wt%, based on a total weight of the composition.

**6.** The composition for encapsulating the organic light-emitting device of claim 1, wherein the monomer represented by Chemical Formula 1 is one or more selected from the group consisting of 1,14-tetradecanediol di(meth)acrylate, 1,15-pentadecanediol di(meth)acrylate, 1,16-hexadecanediol di(meth)acrylate, 1,17-heptadecanediol di(meth)acrylate, and 1,18-octadecanediol di(meth)acrylate.

**7.** The composition for encapsulating the organic light-emitting device of claim 1, wherein the monomer represented by Chemical Formula 2 is one or more selected from the group consisting of isotetradecyl (meth)acrylate, isopentadecyl (meth)acrylate, isohexadecyl (meth)acrylate, isoheptadecyl (meth)acrylate, and isooctadecyl (meth)acrylate.

**8.** The composition for encapsulating the organic light-emitting device of claim 1, wherein the monomer represented by Chemical Formula 3 is one or more selected from the group consisting of bisphenol-A ethylene oxide diacrylate, bisphenol-A ethylene oxide dimethacrylate, bisphenol-A ethoxylate diacrylate, bisphenol-A polyethoxylate diacrylate, and bisphenol-A diacrylate.

**9.** The composition for encapsulating the organic light-emitting device of claim 4, wherein a photocurable monomer represented by Chemical Formula 4 is a compound represented by Chemical Formula 7:

[Chemical Formula 7]

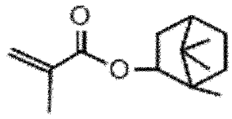

.

**10.** The composition for encapsulating the organic light-emitting device of claim 4, wherein a photocurable monomer represented by Chemical Formula 5 is a monomer selected from the group consisting of Chemical Formulae A-1 to A-3:

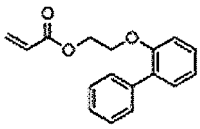

A-1

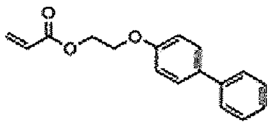

A-2

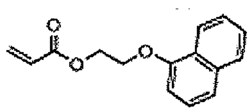

A-3

.

**11.** The composition for encapsulating the organic light-emitting device of claim 4, wherein a photocurable monomer represented by Chemical Formula 6 is ethylene propylene diene monomer (EPDM).

**12.** The composition for encapsulating the organic light-emitting device of claim 1, wherein the photopolymerization initiator is one or more selected from the group consisting of triazine-based, acetophenone-based, benzophenone-based, thioxanthone-based, benzoin-based, phosphorus-based, oxime-based, and a mixture thereof.

**13.** The composition for encapsulating the organic light-emitting device of claim 1, wherein an amount of the photopolymerization initiator is 0.1 wt% to 10 wt%, based on a total weight of the composition.

**14.** The composition for encapsulating the organic light-emitting device of claim 1, further comprising one or more

additives selected from the group consisting of a surfactant, a curing accelerator, and an antioxidant.

**15.** An organic light-emitting display apparatus comprising an encapsulation portion containing the composition for encapsulating the organic light-emitting device of any one of claims 1 to 14.

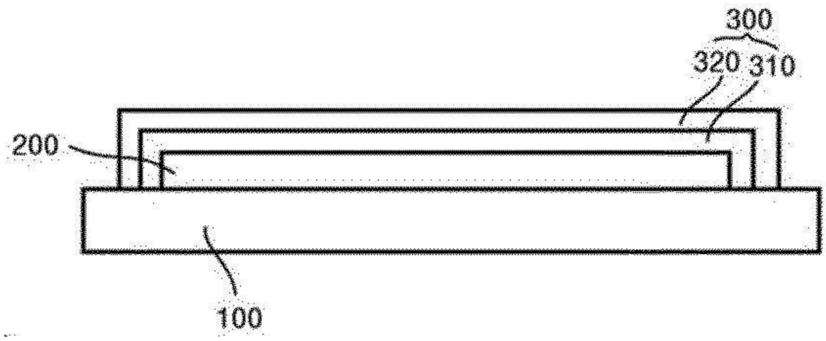


FIGURE 1

## INTERNATIONAL SEARCH REPORT

International application No. **PCT/KR2023/006829**

**A. CLASSIFICATION OF SUBJECT MATTER**

**C08F 222/10**(2006.01)i; **C08F 220/18**(2006.01)i; **C08F 2/50**(2006.01)i; **C09D 4/00**(2006.01)i; **H10K 59/10**(2023.01)i

According to International Patent Classification (IPC) or to both national classification and IPC

**B. FIELDS SEARCHED**

Minimum documentation searched (classification system followed by classification symbols)

C08F 222/10(2006.01); C08F 2/44(2006.01); C08F 20/10(2006.01); C08J 5/18(2006.01); C09D 7/63(2018.01); C09K 3/10(2006.01); G02B 1/04(2006.01); G02B 5/22(2006.01); H01L 27/32(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal), STN (Registry, CAplus) & keywords: 유기발광소자(OLED, organic light emitting diode), 봉지(encapsulation), 단량체(monomer)

**C. DOCUMENTS CONSIDERED TO BE RELEVANT**

| Category* | Citation of document, with indication, where appropriate, of the relevant passages | Relevant to claim No. |
|---|---|---|
| X<br>Y | KR 10-2019-0107262 A (SAMSUNG DISPLAY CO., LTD.) 19 September 2019 (2019-09-19)<br>See claims 1 and 9-11; and paragraphs [0001], [0241] and [0242]. | 1-10,12-15<br>11 |
| Y | JP 2018-131491 A (AICA KOGYO CO., LTD.) 23 August 2018 (2018-08-23)<br>See example 1. | 11 |
| A | KR 10-2020-0078559 A (DENKA COMPANY LIMITED) 01 July 2020 (2020-07-01)<br>See entire document. | 1-15 |
| A | WO 2022-207313 A1 (SONY GROUP CORPORATION et al.) 06 October 2022 (2022-10-06)<br>See entire document. | 1-15 |
| A | KR 10-2014-0014607 A (DONGWOO FINE-CHEM CO., LTD.) 06 February 2014 (2014-02-06)<br>See entire document. | 1-15 |

☐ Further documents are listed in the continuation of Box C. ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **20 September 2023** | **20 September 2023** |
| Name and mailing address of the ISA/KR<br>**Korean Intellectual Property Office**<br>**Government Complex-Daejeon Building 4, 189 Cheongsa-ro, Seo-gu, Daejeon 35208**<br>Facsimile No. **+82-42-481-8578** | Authorized officer<br><br>Telephone No. |

Form PCT/ISA/210 (second sheet) (July 2022)

**INTERNATIONAL SEARCH REPORT**
**Information on patent family members**

International application No.
**PCT/KR2023/006829**

| Patent document cited in search report | | | Publication date (day/month/year) | Patent family member(s) | | | Publication date (day/month/year) |
|---|---|---|---|---|---|---|---|
| KR | 10-2019-0107262 | A | 19 September 2019 | CN | 110246980 | A | 17 September 2019 |
| | | | | EP | 3537493 | A1 | 11 September 2019 |
| | | | | KR | 10-2019-0117867 | A | 17 October 2019 |
| | | | | KR | 10-2544243 | B1 | 19 June 2023 |
| | | | | US | 11004918 | B2 | 11 May 2021 |
| | | | | US | 2019-0280064 | A1 | 12 September 2019 |
| JP | 2018-131491 | A | 23 August 2018 | JP | 6625079 | B2 | 25 December 2019 |
| KR | 10-2020-0078559 | A | 01 July 2020 | CN | 111345116 | A | 26 June 2020 |
| | | | | CN | 111345116 | B | 04 April 2023 |
| | | | | JP | 2021-153061 | A | 30 September 2021 |
| | | | | JP | 6936330 | B2 | 15 September 2021 |
| | | | | JP | 7203903 | B2 | 13 January 2023 |
| | | | | TW | 201923018 | A | 16 June 2019 |
| | | | | TW | I773843 | B | 11 August 2022 |
| WO | 2022-207313 | A1 | 06 October 2022 | | None | | |
| KR | 10-2014-0014607 | A | 06 February 2014 | | None | | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Non-patent literature cited in the description


- *CHEMICAL ABSTRACTS*, 168473-14-1
- *CHEMICAL ABSTRACTS*, 41637-38-1
- *CHEMICAL ABSTRACTS*, 5888-33-5
- *CHEMICAL ABSTRACTS*, 93841-48-6
- *CHEMICAL ABSTRACTS*, 25034-71-3
- *CHEMICAL ABSTRACTS*, 162881-26-7